# FASCICULE DE BREVET EUROPEEN

(11) **EP 2 732 545 B1**
(45) Date de publication et mention de la délivrance du brevet: **25.11.2015**
(21) Numéro de dépôt: 12738073.1
(22) Date de dépôt: 09.07.2012
(51) Int. Cl.: H02N 2/18, H01L 41/113

(54) **SYSTEME DE CONVERSION D'ENERGIE THERMIQUE EN ENERGIE ELECTRIQUE**
SYSTEM ZUR UMWANDLUNG VON THERMISCHER ENERGIE IN ELEKTRISCHE ENERGIE
SYSTEM FOR CONVERTING THERMAL ENERGY INTO ELECTRICAL ENERGY

(30) Priorité: 11.07.2011 FR 1156280
(43) Date de publication de la demande: 21.05.2014
(73) Titulaire: Commissariat à l'Énergie Atomique et aux Énergies Alternatives, 75015 Paris (FR); STMicroelectronics (Crolles 2) SAS, 38920 Crolles (FR)
(72) Inventeur: SAVELLI, Guillaume, F-38000 Grenoble (FR); CORONEL, Philippe, F-38530 Barraux (FR); MONFRAY, Stéphane, F-38320 Eybens (FR); SKOTNICKI, Thomas, F-38920 Crolles-Monfort (FR)
(74) Mandataire: Ahner, Philippe
(86) Numéro de dépôt international: PCT/EP2012/063413
(87) Numéro de publication internationale: WO 2013/007693

(56) Documents cités:
- EP-A1- 2 309 560
- JP-A- 2006 158 112
- KR-A- 20110 006 884
- JUNG S M ET AL: "Energy-harvesting device with mechanical frequency-up conversion mechanism for increased power efficiency and wideband operation", APPLIED PHYSICS LETTERS, AIP, AMERICAN INSTITUTE OF PHYSICS, MELVILLE, NY, US, vol. 96, no. 11, 19 mars 2010 (2010-03-19) , pages 111906-111906, XP012130425, ISSN: 0003-6951, DOI: 10.1063/1.3360219

## Description

### DOMAINE TECHNIQUE ET ART ANTÉRIEUR

La présente invention se rapporte à un système de conversion d'énergie thermique en énergie électrique.

Les circuits électroniques, lors de leur fonctionnement, produisent de la chaleur. Cette chaleur n'est pas utilisée et doit être évacuée afin de ne pas détériorer les circuits.

Il est envisagé de récupérer cette chaleur pour la convertir en énergie électrique.

Il existe des dispositifs de conversion d'énergie mécanique en énergie électrique, par exemple mettant en oeuvre des matériaux piézoélectriques.

Un matériau piézoélectrique est un matériau qui, lorsqu'il est soumis à une déformation mécanique, se polarise électriquement et génère une tension électrique.

Il existe également des structures offrant une très grande aptitude à la déformation sous l'effet de la température. Il s'agit par exemple des bilames. Un bilame est formé de deux lames de métaux ou d'alliages différents à coefficients de dilatation différents, souples, soudées ou collées l'une contre l'autre, dans le sens de la longueur. Du fait des coefficients de dilatation différent, le bilame se déforme avec une grande amplitude à la fois lorsqu'il est échauffé et lorsqu'il est refroidi. Lorsqu'il se déforme celui-ci se courbe. L'orientation de la courbure dépend de la température à laquelle il est soumis.

Le document EP 2 309 560 décrit un générateur thermoélectrique comportant une membrane suspendue disposée entre une source chaude et une source froide, et apte à prendre une première forme lorsque sa température atteint un premier seuil et une seconde forme lorsque sa température atteint un deuxième seuil. La membrane comporte une couche support sur laquelle est prévue une couche en matériau piézoélectrique.

### EXPOSÉ DE L'INVENTION

Le but de la présente invention est d'offrir un système de conversion d'énergie thermique en énergie électrique de structure simple et offrant un rendement de récupération élevé.

Le but précédemment énoncé est atteint par un système comportant un élément dont la forme varie entre deux configurations en fonction de la température à laquelle il est soumis, par exemple un bilame.

Celui-ci est destiné à être logé entre une source chaude et une source froide et un matériau piézoélectrique qui est mis en vibration par la déformation de l'élément sensible, le matériau piézoélectrique étant disposé de sorte qu'il ne s'interpose pas entre le bilame et la source chaude ou la source froide.

En d'autres termes, on déporte le matériau piézoélectrique en dehors de l'espace entre l'élément sensible et les zones chaude et froide de sorte que le matériau piézoélectrique ne diminue pas l'effet de la température sur la déformation de l'élément sensible, ni sa déformation.

De manière très avantageuse, le matériau piézoélectrique est suspendu directement sur l'élément sensible. Ainsi il est mis en vibration à chaque changement de configuration, lorsque l'élément sensible est échauffé et lorsque l'élément sensible est refroidi. Ainsi la quantité d'énergie thermique convertie est augmentée.

De manière également très avantageuse, dans au moins une de ses configurations, l'élément sensible est en contact avec la source chaude ou froide.

La présente invention a alors pour objet un système de conversion d'énergie thermique en énergie électrique selon la revendication 1, le système comportant au moins un élément sensible à la température, dit élément sensible, adapté à être disposé dans un espace délimité par une source chaude et une source froide situées en face l'une de l'autre, ledit élément sensible s'étendant le long d'un axe longitudinal, au moins un élément suspendu solidaire en mouvement de l'élément sensible et s'étendant latéralement à partir de l'élément sensible et comportant une extrémité libre, et au moins un élément piézoélectrique suspendu, ledit élément piézoélectrique étant disposé par rapport à l'élément suspendu de sorte qu'il soit mis en vibration lorsque l'élément sensible change de configuration, ledit élément piézoélectrique étant destiné à être situé en dehors de l'espace défini entre l'élément sensible et la source chaude et en dehors de l'espace entre l'élément sensible et la source froide.

Selon un exemple de réalisation, l'élément piézoélectrique est suspendu à une pièce fixe par rapport à l'élément sensible et est mis en vibration par l'élément suspendu.

L'élément suspendu peut s'étendre de part et d'autre de l'axe longitudinal de l'élément sensible.

L'élément sensible dans au moins une de ses formes peut être en contact avec l'une ou l'autre des sources chaude et froide.

L'élément suspendu peut être réalisé d'un seul tenant avec l'élément sensible.

Avantageusement, le système peut comporter une masse suspendue à l'élément piézoélectrique.

Par exemple, l'élément sensible est un bilame.

En variante, l'élément sensible est un élément en alliage à mémoire de forme.

Le système peut comporter plusieurs éléments suspendus disposés les uns à côté des autres s'étendant chacun latéralement à partir de l'élément sensible.

Le système de conversion forme par exemple un dispositif de récupération d'énergie, l'élément piézoélectrique étant relié électriquement à un moyen de stockage de l'électricité produite. Le système peut former un capteur de vibration.

La présente invention a également pour objet un ensemble de conversion d'énergie thermique en énergie électrique comportant une source chaude et une source froide situées en face l'une de l'autre et un système de conversion selon la présente invention, ledit système de conversion étant disposé entre la source chaude et la source froide de telle sorte que l'élément piézoélectrique soit destiné à être situé en dehors de l'espace défini entre l'élément sensible et la source chaude et en dehors de l'espace entre l'élément sensible et la source froide. La source chaude est par exemple alimentée thermiquement par un système électronique.

### BRÈVE DESCRIPTION DES DESSINS

La présente invention sera mieux comprise à l'aide de la description qui va suivre et des dessins sur lesquels :
- la figure 1A est une vue en perspective d'un exemple de réalisation d'un système représenté de manière schématique et placé entre une source chaude et une source froide,
- la figure 1B est une vue de côté du système de la figure 1A,
- la figure 2 est une vue en perspective d'une variante de réalisation du système de la figure 1A,
- la figure 3 est une autre variante de réalisation du système de la figure 1A,
- les figures 4A et 4B sont des vues en perspective d'un exemple de réalisation du système selon l'invention,
- la figure 5 est une vue en perspective d'une variante de réalisation du système des figures 4A et 4B,
- la figure 6 est une vue en perspective d'une autre variante de réalisation du système des figures 4A et 4B.

### EXPOSÉ DÉTAILLÉ DE MODES DE RÉALISATION PARTICULIERS

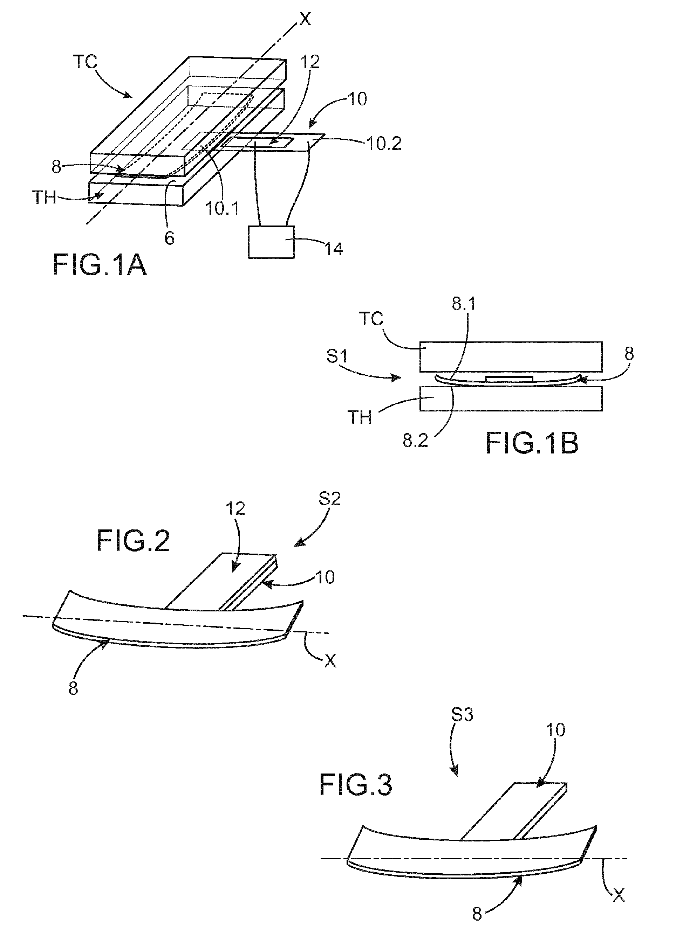

Sur les figures 1A et 1B, on peut voir un exemple de réalisation d'un système S1 sensible à la température.

Le système S1 comporte une source chaude TH et une source froide TC disposées l'une en face de l'autre et délimitant entre elle un espace 6.

Dans l'exemple représenté, les sources sont schématisées par des surfaces planes, mais on peut envisager toute forme, surfaces concaves, convexes.... La source chaude peut être formée par des cordons chauffants souples ou des réservoirs fermés par une membrane et dont le volume varie avec la température.

Pour la source froide, on peut envisager un courant d'air, des moyens mécaniques seront alors prévus pour localiser ce courant d'air.

Le système S1 comporte un élément sensible à la température 8, désigné par la suite élément sensible, d'axe longitudinal X et un élément 10 fixé à l'élément sensible 8 et s'étendant transversalement par rapport à l'axe longitudinal X. L'élément 10 sera désigné par élément suspendu.

L'élément sensible 8 est logé dans l'espace 6. L'élément sensible 8 est disposé entre la source chaude TH et la source froide TC de telle manière que l'une de ses faces 8.1 soit en regard de la source froide TC et sa face opposée 8.2 soit en regard de la source chaude.

Dans l'exemple représenté, l'élément 10 a la forme d'une plaque fixée par une extrémité longitudinale 10.1 à la face de l'élément sensible 8.1, l'autre extrémité longitudinale 10.2 étant libre.

Le système comporte également un élément en matériau piézoélectrique 12, désigné par la suite élément piézoélectrique, situé sur une face de l'élément suspendu 10.

L'élément piézoélectrique est connecté électriquement à une charge 14, par exemple une batterie ou un dispositif consommateur, pour récupérer l'électricité générée par celui-ci.

On entend par " élément sensible à la température " dans la présente demande, un élément possédant deux formes et aptes à passer de l'une à l'autre sous l'effet d'une variation de température.

L'élément sensible 8 peut être formé par un bilame. Comme cela a été indiqué précédemment, un bilame est formé de deux lames en métal ou alliage différent présentant des coefficients de dilatation différents, les deux lames étant solidarisés par soudage ou collage de sorte à former un élément monolithique. Ainsi lorsque l'une des lames se dilate, le bilame va se courber. Lorsque le bilame est échauffé, il passe d'une première configuration à une deuxième configuration, on désigne ce changement le " cloquage " et lorsqu'il refroidit il revient à sa première configuration, ce changement est désigné " décloquage ".

L'élément sensible 8 peut également être formé par un élément en alliage à mémoire de forme ayant mémorisé deux formes.

Des exemples de bilames et d'alliages à mémoire de forme seront donnés par la suite.

Dans la suite de la description, nous prendrons le bilame comme " élément sensible ".

Comme cela est schématisé sur les figures 1 à 5, le bilame présente une courbure : lors de son changement de configuration, il passe d'un état courbé à un état courbé opposé.

De préférence, le bilame est dimensionné et est monté dans l'espace 6 de telle manière que dans un premier état l'une de ses faces 8.1, 8.2 soit proche et, de préférence en contact avec la source chaude ou froide et que dans un deuxième état l'autre des faces 8.2, 8.1 soit proche, et de préférence en contact avec la source froide ou la source chaude. Ainsi le transfert thermique entre les sources chaude et froide et le bilame est direct et leur effet sur le bilame est amélioré, la fréquence de déformation du bilame est alors optimisée. C'est la zone centrale du bilame présentant la plus grande courbure qui entre en contact des sources.

De préférence, le bilame est dimensionné de sorte que lorsqu'il change de configuration, sa déformation soit le moins possible amortie par un choc contre les sources afin de ne pas réduire l'énergie transmise à l'élément piézoélectrique.

Nous allons maintenant expliquer le fonctionnement du système S1.

Considérons qu'à l'état repos, le bilame 8 soit en contact avec la source chaude TH.

Le bilame 8 est échauffé, les matériaux dont les lames sont composées se dilatent, l'un plus que l'autre du fait des coefficients de dilatation différents ; au-delà d'un certain seuil de dilatation survient une inversion de la courbure du bilame qui entre en contact avec la source froide. Ce changement de configuration du bilame provoque une mise en vibration de l'élément suspendu 10 et de fait de l'élément piézoélectrique. Celui-ci se polarise et génère une tension électrique qui peut être récupérée par la charge 14. La mise en vibration est d'autant plus importante que le changement de configuration est brusque ou sec. Cela correspond à la valeur de la force délivrée au moment de la déformation. Cette force est mesurée par exemple par un capteur de force. Selon l'application, il pourra être requis que la valeur de la force soit supérieure à une valeur seuil.

Le bilame, qui est désormais en contact avec la source froide, se refroidit, les deux lames se contractent, ce qui provoque une nouvelle inversion de la courbure. Ce nouveau changement de configuration provoque à nouveau une mise en vibration de l'élément suspendu 10 et de l'élément piézoélectrique, qui génère une tension électrique.

Cet exemple est particulièrement avantageux car il permet une mise en vibration de l'élément piézoélectrique à chaque changement de configuration du bilame, ce qui optimise la quantité d'électricité produite.

Dans l'exemple représenté et de manière avantageuse également, l'élément suspendu est fixé au bilame dans la partie centrale de celui-ci de sorte qu'il voit la plus grande amplitude de déplacement du bilame. Sa mise en vibration est donc maximale.

L'élément suspendu peut être fixé au bilame de manière décentrée.

Avantageusement, on peut prévoir que l'élément piézoélectrique soit situé à l'extrémité libre de l'élément suspendu.

Sur la figure 2, on peut voir un système S2 dans lequel l'élément piézoélectrique 12 recouvre entièrement une face de l'élément suspendu 10. Il est à noter que plus la surface de l'élément piézoélectrique est grande plus la quantité d'électricité potentiellement produite est grande. En variante, les deux faces de l'élément suspendu peuvent être recouvertes d'un élément piézoélectrique 12.

Sur la figure 3, on peut voir un système S3 dans lequel l'élément suspendu 10 est directement réalisé en matériau piézoélectrique. L'élément piézoélectrique présente un plus grand volume, en particulier une plus grande épaisseur par rapport à celui de la figure 2, sans augmenter l'encombrement ni la masse du système. Ceci est particulièrement intéressant car la réponse en tension et la quantité d'énergie récupérée dépendent de l'épaisseur du matériau piézoélectrique.

Par exemple, l'élément piézoélectrique est fixé au bilame par collage.

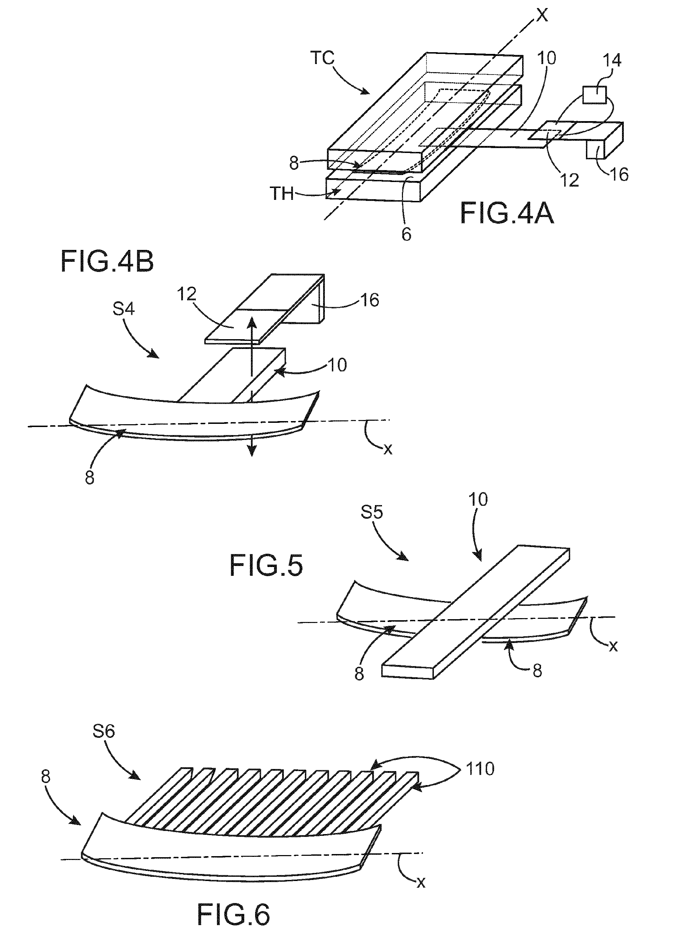

Sur les figures 4A, 4B, 5 et 6, on peut voir un exemple de réalisation d'un système selon l'invention dans lequel l'élément piézoélectrique 12 n'est pas directement supporté par l'élément suspendu 10. Les sources chaude et froide ne sont pas représentées.

Sur les figures 4A et 4B, le système S4 comporte un élément piézoélectrique 12 suspendu par une extrémité longitudinale à un support 16 et est orienté de sorte que son extrémité longitudinale opposée soit sollicitée en mouvement par l'élément suspendu 10 lorsque le bilame 8 passe de l'une des configurations à l'autre des configurations. L'élément piézoélectrique 12 est situé en dessus ou au dessous de l'élément suspendu 10. L'élément piézoélectrique 12 et le support 16 sont situés en dehors de l'espace défini entre le bilame 8 et la source chaude TH et en dehors de l'espace entre le bilame 8 et la source froide TC. L'élément piézoélectrique 8 est connecté électriquement à une charge 14, par exemple une batterie ou un dispositif consommateur, pour récupérer l'électricité générée par celui-ci.

Plus généralement, le système comporte un élément piézoélectrique fixé sur un support et situé sur la trajectoire du bilame de sorte à être sollicité par lui lors des changements de configuration du bilame.

Le fonctionnement de ce système est similaire à celui du système représenté sur la figure 1.

Grâce à cette configuration, l'élément piézoélectrique 12 n'interfère pas avec les zones froide et chaude. Puisqu'il est déporté à l'extérieur de l'espace entre la source chaude et la source froide, il n'entre pas en contact avec ces zones. En outre, l'élément piézoélectrique ne participe pas à l'équilibre thermique autour du bilame. Ceci a pour effet d'assurer un meilleur contact du bilame avec les zones froide et chaude, ce qui permet d'augmenter la fréquence de vibration.

En outre, l'élément piézoélectrique subit le choc de l'élément suspendu 10 associé au bilame, ainsi l'énergie due au choc de l'élément suspendu sur l'élément piézoélectrique s'ajoute à l'énergie de vibration. La quantité d'énergie récupérée est donc augmentée.

Ce dispositif de récupération offre également une liberté étendue dans le choix du matériau formant l'élément piézoélectrique car il n'y a plus à tenir compte des phénomènes de transfert thermique.

Par ailleurs, l'élément piézoélectrique n'étant pas solidaire du bilame, on peut ajuster la courbure du bilame afin d'adapter sa fréquence à la fréquence optimale sans interférer avec le ou les éléments piézoélectriques.

Sur la figure 5, on peut voir une variante S5 du système S4 de la figure 4, dans laquelle l'élément suspendu 10 s'étend de part et d'autre de l'axe longitudinal X du bilame 8. Le système comporte deux éléments piézoélectriques suspendus sur un support symétriquement par rapport à l'axe longitudinal et aptes être mis en vibration par les deux extrémités libres de l'élément suspendu. La quantité d'énergie produite peut alors être multipliée par deux par rapport au système de la figure 4.

Sur la figure 6, on peut voir une autre variante de réalisation, dans laquelle le système S6 comporte une pluralité d'éléments suspendus 110 s'étendant transversalement le long du bilame 8 et formant un peigne. Chaque élément suspendu 110 est alors destiné à solliciter un ou plusieurs éléments piézoélectriques (non représenté). La quantité d'énergie produite peut alors être augmentée. On peut également envisager qu'un élément piézoélectrique soit sollicité par plusieurs éléments suspendus.

Cette variante de réalisation permet de réaliser un système dans lequel les éléments suspendus réagissent à des températures différentes en choisissant les dimensions et/ou des géométries de chacun. En adaptant les éléments piézoélectriques aux éléments suspendus qui les sollicitent, on peut par exemple couvrir une gamme de fréquences plus étendue.

On peut prévoir de manière également avantageuse d'associer plusieurs systèmes selon l'exemple de réalisation des figures 4 à 6, chacun étant adapté pour réagir à une température donné. Par exemple, tous les systèmes réagissent aux mêmes températures ou alors ils réagissent à des températures différentes, dans ce dernier cas les systèmes assurent un fonctionnement dans une gamme de température étendue, ils peuvent être avantageusement utilisés dans le cas où la température de la source chaude et/ou celle de la source froide varie.

Dans une autre variante, on associe mécaniquement plusieurs systèmes des figures 4 à 6 de sorte que le cloquage ou décloquage d'un bilame de l'un des systèmes provoque par réaction le cloquage du bilame du système voisin.

Grâce à ces variantes de réalisation, les performances peuvent être améliorées.

On peut réaliser un système similaire à celui de la figure 5 comportant un élément suspendu s'étendant transversalement au bilame et de part et d'autre de celui-ci, et deux éléments piézoélectriques fixés sur l'une des faces de l'élément suspendu de part et d'autre du bilame. Ce système présente l'avantage par rapport au système de la figure 1A, de produire deux fois plus d'électricité, puisqu'il comporte deux éléments piézoélectriques mis simultanément en vibration.

L'élément suspendu n'est pas nécessairement orthogonal à l'axe longitudinal, et on peut envisager qu'il forme un certain angle avec celui-ci. On peut prévoir également qu'il ne s'étende pas dans le plan de l'élément sensible.

De manière avantageuse, le ou les élément(s) suspendu(s) est ou sont réalisé(s) d'un seul tenant avec l'élément sensible ce qui simplifie la réalisation et réduit les pertes d'énergie pour activer l'élément piézoélectrique.

Une masse peut être prévue à l'extrémité libre de l'élément piézoélectrique pour faciliter sa mise en résonance.

En variante, l'élément suspendu et/ou l'élément piézoélectrique peut présenter une variation de forme, de masse, d'épaisseur, de topographie, de symétrie ... de sorte à améliorer la mise en résonance de l'élément piézoélectrique et ainsi augmenter l'énergie récupérée.

On peut également envisager de disposer plusieurs systèmes dans l'espace délimité par la source chaude et la source froide.

On peut envisager que les surfaces des sources chaude et froide soient suffisamment grandes pour que le système de conversion soit disposé entièrement dans l'espace délimité entre les deux sources. Le système est configuré de telle sorte qu'il n'y ait pas d'interaction mécanique entre l'élément piézoélectrique et/ou l'élément suspendu et les sources.

Le système peut présenter des dimensions macroscopiques, par exemple avoir des surfaces de l'ordre de plusieurs cm².

Dans ce cas, le bilame est par exemple à base d'alliages Fe-Ni de différentes compositions, comme l'INVAR®. Ces alliages peuvent contenir également du chrome et/ou manganèse peuvent être ajoutés, ce qui pour effet d'augmenter leur coefficient de dilatation.

Le ou les éléments piézoélectriques peut ou peuvent être formé(s) à base de TZP (Titano-zirconate de plomb ou PZT en anglais). On peut utiliser des matériaux ferroélectriques de structures pérovskite, par exemple du titanate de plomb PbTiO₃, du titanate de baryum BaTiO₃, le niobate de potassium KNbO₃, des semi-conducteurs des groupes III-V de structure wurtite ou encore des polymères de synthèse, comme par exemple le polyvinylidine difluoride (PVDF) (-CH₂-CF₂)ₙ et ses dérivés.

Les dimensions du système selon l'invention peuvent également être micrométriques. Les bilames peuvent être réalisés en technologie couches minces à partir de silicium et d'un métal, par exemple de l'aluminium. De tels bilames ont été décrits dans les articles W. Riethmueller, IEEE, Trans. ELec. Dev. ED-35, 1998 et dans H Jerman, J. Micromech. Microeng. 4, 1994*.* L'épaisseur de chaque couche est alors par exemple de l'ordre de la dizaine de micromètres. Des associations telles que Si-Al, SiO₂-AL, Si-Au, SiO₂-Au e, Si-Pb... peuvent être utilisées.

Le ou les éléments piézoélectriques peut ou peuvent être formé(s) à l'échelle microscopique avec du ZnO ou encore de l'AlN.

Dans le cas d'élément sensibles réalisés en alliages à mémoire de forme, ceux-ci peuvent être réalisés par exemple en CuZn, CuZnAl, CuNiAl, AuCd, FePt. Le choix et la stoechiométrie des matériaux sont faits en fonction de la plage de température d'utilisation fixée par les sources chaudes et froide.

Par exemple, la surface du bilame peut s'étendre de quelques mm² à plusieurs dizaines de cm² pour une épaisseur de quelques dizaines de µm à plusieurs centaines de µm, de même pour les éléments sensibles réalisés en alliages à mémoire de forme. De préférence, le bilame présente une épaisseur faible de sorte que son volume soit réduit afin que sa température soit rapidement celle de la source chaude ou de la source froide, tout en maintenant suffisamment d'amplitude de déformation pour pouvoir la transmettre à l'élément piézoélectrique.

Par exemple, un tel système peut fournir quelques dizaines de µW.

On choisit un bilame, plus particulièrement les matériaux des lames du bilame, de telle sorte que les deux températures de transition provoquant le cloquage et le décloquage du bilame soient rapprochées afin que le bilame présente une fréquence élevée et ainsi mette en vibration l'élément piézoélectrique avec une fréquence élevée.

De préférence, le bilame se situe, dans chacune de ses configurations, très proche de l'une des sources et de manière préférée il est en contact direct avec celles-ci afin que sa température soit rapidement celle de la source avec laquelle il est en contact.

Ainsi il n'y a pas de perte en fréquence du bilame, celui-ci étant soumis à la température de l'une des sources de manière très efficace. En outre, l'amplitude de l'élément piézoélectrique n'est pas diminuée par rapport à un système dans lequel l'élément piézoélectrique serait par exemple sur la source froide.

A titre d'exemple pour un système macroscopique, le bilame peut présenter les dimensions suivantes : une longueur de 3,5 cm, une largeur de 2 cm et une épaisseur de 140 µm, avec des températures de transition du bilame sont de 120°C et 105°C. L'élément piézoélectrique peut présenter les dimensions suivantes : une longueur de 5,4 cm, une largeur de 1,3 cm et une épaisseur de 200 µm. La distance entre les sources chaude et froide est par exemple de 700 µm.

Grâce à l'invention, une énergie thermique est convertie en énergie électrique via une énergie mécanique. L'énergie électrique peut être utilisée comme source d'énergie pour alimenter une charge, formant ainsi un système de récupération d'énergie.

Il peut également être utilisé pour transférer des informations supplémentaires, par exemple le système peut être utilisé comme capteur de vibrations et être relié à une action, telle qu'une alarme, un contrôle...

Par ailleurs, il peut être intéressant de choisir un matériau piézoélectrique de capacité thermique telle qu'il absorbe la chaleur du bilame puisqu'il est en contact avec lui. Cela peut ainsi aider à la régulation thermique du bilame et par là à optimiser sa fréquence de fonctionnement.

## Revendications

1. Système de conversion d'énergie thermique en énergie électrique comportant au moins un élément sensible à la température (8), dit élément sensible, dont la forme varie entre deux configurations en fonction de la température à laquelle il est soumis, ledit élément sensible étant adapté pour être disposé dans un espace (6) délimité par une source chaude (TH) et une source froide (TC) situées en face l'une de l'autre, ledit élément sensible (8) s'étendant le long d'un axe longitudinal (X), **caractérisé en ce que** le système comporte au moins un élément suspendu (10, 110) solidaire en mouvement de l'élément sensible (8) et s'étendant latéralement à partir de l'élément sensible (8) et comportant une extrémité libre, et au moins un élément piézoélectrique (12) suspendu, ledit élément piézoélectrique étant disposé par rapport à l'élément suspendu (10, 110) de sorte qu'il soit mis en vibration lorsque l'élément sensible (8) change de configuration, ledit élément piézoélectrique (12) étant destiné à être situé en dehors de l'espace défini entre l'élément sensible (8) et la source chaude (TH) et en dehors de l'espace entre l'élément sensible (8) et la source froide (TC), dans lequel l'élément piézoélectrique (12) est suspendu à une pièce fixe par rapport à l'élément sensible et est mis en vibration par l'élément suspendu (10, 110).

2. Système de conversion selon la revendication 1, dans lequel l'élément sensible (8) dans au moins une de ses formes est en contact avec l'une ou l'autre des sources chaude (TH) et froide (TC).

3. Système selon la revendication 1 ou 2, dans lequel l'élément suspendu (10, 110) est réalisé d'un seul tenant avec l'élément sensible (8).

4. Système de conversion selon l'une des revendications 1 à 3, dans lequel l'élément suspendu (10, 110) s'étend de part et d'autre de l'axe longitudinal (X) de l'élément sensible (8).

5. Système de conversion selon l'une des revendications 1 à 4, comportant une masse suspendue à l'élément piézoélectrique.

6. Système de conversion selon l'une des revendications 1 à 5, dans lequel l'élément sensible (8) est un bilame.

7. Système de conversion selon l'une des revendications 1 à 5, dans lequel l'élément sensible (8) est un élément en alliage à mémoire de forme.

8. Système de conversion selon l'une des revendications 1 à 7, comportant plusieurs éléments suspendus (110) disposés les uns à côté des autres s'étendant chacun latéralement à partir de l'élément sensible (8).

9. Système de conversion selon l'une des revendications 1 à 8, formant un dispositif de récupération d'énergie, l'élément piézoélectrique étant relié électriquement à un moyen de stockage (14) de l'électricité produite.

10. Système de conversion selon l'une des revendications 1 à 9, formant un capteur de vibration.

11. Ensemble de conversion d'énergie thermique en énergie électrique comportant une source chaude et une source froide situées en face l'une de l'autre et un système de conversion selon l'une des revendications 1 à 10, ledit système de conversion étant disposé entre la source chaude et la source froide de telle sorte que l'élément piézoélectrique (12) soit destiné à être situé en dehors de l'espace défini entre l'élément sensible (8) et la source chaude (TH) et en dehors de l'espace entre l'élément sensible (8) et la source froide (TC).

12. Ensemble de conversion selon la revendication 11, dans lequel la source chaude (TH) est alimentée thermiquement par un système électronique.

## Patentansprüche

1. System zur Umwandlung von thermischer Energie in elektrische Energie, wobei das System zumindest ein temperaturempfindliches Element (8), das sogenannte empfindliche Element, aufweist, dessen Form zwischen zwei Konfigurationen aufgrund der Temperatur, welcher es unterzogen wird, variiert, wobei das empfindliche Element so angepasst ist, dass es in einem Raum (6) angeordnet ist, welcher von einer Wärmequelle (TH) und einer Kältequelle (TC) begrenzt wird, welche einander gegenüber liegen, wobei sich das besagte empfindliche Element (8) entlang einer Längsachse (X) erstreckt, **dadurch gekennzeichnet, dass** das System mindestens ein Hängeelement (10, 110) aufweist, welches bewegungsfest mit dem empfindlichen Element (8) verbunden ist und welches sich seitlich von dem empfindlichen Element (8) erstreckt und ein freies Ende aufweist, und das System mindestens ein hängendes piezoelektrisches Element (12) aufweist, wobei das piezoelektrische Element im Verhältnis zu dem Hängeelement (10, 110) so angeordnet ist, dass es in Schwingung versetzt wird, wenn das empfindliche Element (8) die Konfiguration verändert, wobei das besagte piezoelektrische Element (12) dazu bestimmt ist, außerhalb des Raums angeordnet zu werden, welcher zwischen dem empfindlichen Element (8) und der Wärmequelle (TH) festgelegt ist, und außerhalb des Raums zwischen dem empfindlichen Element (8) und der Kältequelle (TC), in welchem das piezoelektrische Element (12) an einem im Vergleich zu dem empfindlichen Element ortsfesten Teil aufgehängt ist und von dem Hängeelement (10, 110) in Schwingung versetzt wird.

2. System zur Umwandlung nach Anspruch 1, in welchem das empfindliche Element (8) in zumindest einer seiner Formen in Kontakt mit einer der Wärmequellen (TH) und der Kältequellen (TC) ist.

3. System nach Anspruch 1 oder 2, in welchem das Hängeelement (10, 110) in einem Stück mit dem empfindlichen Element (8) realisiert ist.

4. System zur Umwandlung nach einem der Ansprüche 1 bis 3, in welchem sich das Hängeelement (10, 110) auf beiden Seiten der Längsachse (X) des empfindlichen Elements (8) erstreckt.

5. System zur Umwandlung nach einem der Ansprüche 1 bis 4, wobei das System eine Masse aufweist, welche an dem piezoelektrischen Element aufgehängt ist.

6. System nach einem der Ansprüche 1 bis 5, in welchem das empfindliche Element (8) ein Bimetall ist.

7. System zur Umwandlung nach einem der Ansprüche 1 bis 5, in welchem das empfindliche System (8) ein Element aus einer Legierung mit Formerinnerungsvermögen ist.

8. System zur Umwandlung nach einem der Ansprüche 1 bis 7, welches mehrere Hängeelemente (110) umfasst, die nebeneinander angeordnet sind, wobei sich jedes Hängeelement seitlich von dem empfindlichen Element (8) erstreckt.

9. System zur Umwandlung nach einem der Ansprüche 1 bis 8, welches eine Einrichtung zur Rückgewinnung von Energie bildet, wobei das piezoelektrische Element mit einer Speichervorrichtung (14) für die erzeugte Elektrizität elektrisch verbunden ist.

10. System zur Umwandlung nach einem der Ansprüche 1 bis 9, welches einen Schwingungssensor bildet.

11. Einheit zur Umwandlung von thermischer Energie in elektrische Energie, wobei die Einheit eine Wärmequelle und eine Kältequelle umfasst, welche einander gegenüberliegend angeordnet sind, sowie ein System zur Umwandlung nach einem der Ansprüche 1 bis 10, wobei das System zur Umwandlung zwischen der Wärmequelle und der Kältequelle derart angeordnet ist, dass das piezoelektrische Element (12) zur Anordnung außerhalb des Raums, welcher zwischen dem empfindlichen Element (8) und der Wärmequelle (TH) festgelegt ist, und zur Anordnung außerhalb des Raums zwischen dem empfindlichen Element (8) und der Kältequelle (TC) bestimmt ist.

12. Einheit zur Umwandlung nach Anspruch 11, in welcher die Wärmequelle (TH) von einem elektronischen System thermisch beaufschlagt wird.

## Claims

1. System for converting thermal energy into electrical energy comprising at least one temperature sensitive element (8), called the sensitive element, that can be placed in a space (6) delimited by a hot source (TH) and a cold source (TC) facing each other, said sensitive element (8) extending along a longitudinal axis (X), **characterized in that** the system comprises at least one suspended element (10, 110) fixed in movement to the sensitive element (8) and extending laterally from the sensitive element (8) and comprising a free end, and at least one suspended piezoelectric element (12), said piezoelectric element (12) being arranged relative to the suspended element (10, 110) such that it is vibrated when the sensitive element (8) changes configuration, said piezoelectric element (12) being designed to be located outside the space defined between the sensitive element (8) and the hot source (TH) and outside the space between the sensitive element (8) and the cold source (TC), in which the piezoelectric element (12) is suspended from a part fixed relative to the sensitive element and is vibrated by the suspended element (10, 110).

2. The system according to claim 1, in which the sensitive element is in contact with either the hot source (TH) or the cold source (TC) in at least one of its forms.

3. The system according to claim 1 or 2, in which the suspended element (10, 110) is made as a single-piece with the sensitive element (8).

4. The system according to one of claims 1 to 3, in which the suspended element (10, 110) extends on each side of the longitudinal axis (X) of the sensitive element (8) .

5. The system according to one of claims 1 to 4, comprising a mass suspended from the piezoelectric element.

6. The system according to one of claims 1 to 5, in which the sensitive element (8) is a bimetallic strip.

7. The system according to one of claims 1 to 5, in which the sensitive element (8) is an element made from a shape memory alloy.

8. The system according to one of claims 1 to 7, comprising several suspended elements (110) arranged adjacent to each other each extending laterally from the sensitive element (8).

9. The system according to one of claims 1 to 9, forming an energy recovery device, the piezoelectric element being electrically connected to a storage (14) of the electricity generated.

10. The system according to one of claims 1 to 9, forming a vibration sensor.

11. Assembly for converting thermal energy into electrical energy comprising a hot source and a cold source facing each other and an energy conversion system according one of claims 1 to 10, said conversion system being arranged between the hot source and the cold source such that the piezoelectric element (12) is designed to be located outside the space defined between the sensitive element (8) and the hot source (TH)and outside the space between the sensitive element (8) and the cold source (TC).

12. Conversion assembly according to claim 11, in which heat is supplied to the hot source (TH) by an electronic system.
